# EUROPEAN PATENT APPLICATION

(11) **EP 0 632 687 A1**
(43) Date of publication of application: **04.01.1995**
(21) Application number: 94304586.4
(22) Date of filing: 23.06.1994
(51) Int. Cl.: H05K 9/00, H01L 21/00

(54) **Semiconductor packaging**

(30) Priority: 28.06.1993 JP 155937/93
(71) Applicant: FUJI ELECTRIC CO. LTD., Kawasaki 210 (JP)
(72) Inventor: Ogawa, Shogo, Kawasaki-ku, Kawasaki 210 (JP)
(74) Representative: Topley, Paul

(57) **Abstract**

To provide a packing box for lead terminal type semiconductor products, including insulated gate type semiconductor devices such as MOSFETs and IGBTs, that enables the products in the box to be held securely in place, that allows packing and removal of the products to be done easily, and which prevents gate breakdown due to electrostatic voltages, there is provided a packing box (3) for single in-line lead terminal type semiconductor devices (4), including insulated gate type semiconductor devices, that comprises a box body (3a), internal partitions (3b), and a cover (3c). A conductive foam or sponge (6) also used as a cushioned packing material is attached to the internal surface of the cover (3c), and the semiconductor products (4) are placed in the packing box (3) with their lead terminals (2) directed upwardly. In this packed state, the conductive foam or sponge (6) is pressed against the lead terminals (2) to collectively hold the semiconductor products (4) securely in the box (3), thereby causing short-circuiting between the lead terminals (2) to prevent gate break down as a result of electrostatic voltage.

## Description

The present invention relates to a packing method and a packing box for use with lead terminal type semiconductor devices, including insulated gate type semiconductor devices such as MOSFETs and IGBTs.

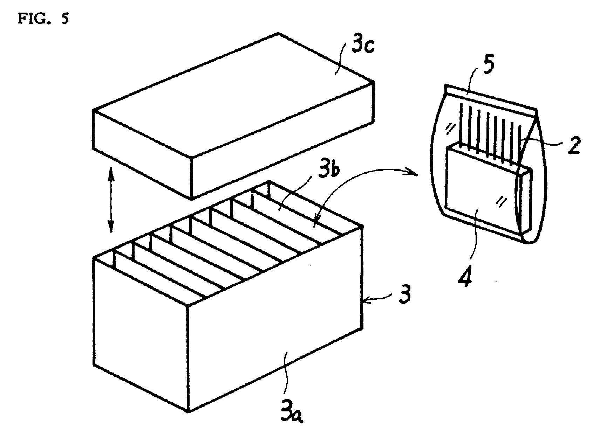

The gates of insulated gate semiconductor devices such as a MOSFETs or IGBTs may break down if electrostatic voltage is applied between their terminals. Therefore, the inadvertent application of electrostatic voltages must be prevented when such semiconductor products are shipped or stored. The semiconductor products, the structure of conventional packing boxes, and the conventional packing procedure are explained with reference to Figures 4 and 5 of the accompanying drawings. Figure 4 is an outline drawing of a single in-line lead terminal semiconductor device, wherein reference numeral 1 represents a resin package incorporating insulated gate semiconductor elements such as MOSFETs and IGBTs alone or in conjunction with other electronic elements, and reference numeral 2 indicates one of a number of lead terminals extending out from package 1 in a parallel coplanar array.

In order to pack such semiconductor products before shipment, a corrugated fibreboard packing box 3 as in Figure 5 has been proposed. The packing box 3 comprises a box body 3a, internal partitions 3b, and an upper cover 3c. When semiconductor products 4 are packed in the packing box 3, each of them is placed in a conductive bag 5, which shields the products from the effects of static electricity. The products are then placed in the box 3 with their lead terminals 2, which have little mechanical strength, directed upwardly. The cover 3c is then placed on the body 3a of the box 3. It has also been proposed, instead of the conductive bag 5, to attach a strip of a conductive material such as metal ribbon across the lead terminals 2 of each semiconductor product to cause short-circuiting, thereby protecting the semiconductor product from breakdown due to electrostatic voltages.

The above conventional packing method is, however, not very efficient because at the packing location each semiconductor product 4 must be individually either placed in a conductive bag, or have other measures taken to protect against breakdown due to electrostatic voltages, before the products can be packed in the packing box 3. This method is also troublesome when the packing box 3 is opened at the destination to remove the semiconductor products 4, because each product 4 must be withdrawn from between the inner partitions 3b of the box body 3a, and the bag 5 must then be removed. Furthermore, the semiconductor products may shake and collide with the cover or side wall of the box 3 as a result of shock or vibrations that may occur during transport, causing the lead terminals 2 to be damaged.

In view of the above problems, it is an object of this invention to provide a packing method and box that solve the problems that often occur with lead terminal type semiconductor products by providing for the products in the box to be securely held in place, to enable simple packing and removal of the products, as well as to protect against breakdown due to electrostatic voltages.

In order to achieve the above object, the packing method of this invention allows a plurality of products to be accommodated in a packing box and an electrically conductive cushioning material to be positioned against the lead terminals of the semiconductor products, to collectively hold the products securely in the box.

The cushioning material used in this packing method is preferably a conductive foam or sponge material into which the lead terminals of the semiconductor products can easily penetrate.

On the other hand, the packing box of this invention, which is used to implement the above packing method for single in-line lead terminal semiconductor devices, incorporates a conductive foam or sponge as a cushioning material for collectively holding the products securely in the box with their lead terminals directed upwardly. The conductive foam or sponge is pressed against the lead terminals of each semiconductor product so that the leads penetrate into the foam or sponge material, which then holds them in place.

The packing box is preferably constituted in such a way that the conductive foam or sponge is attached to the internal surface of the cover of the packing box. In this case, the sponge or foam material should be of a thickness to allow the lead terminals of the semiconductor device to penetrate into the sponge, but not to reach the cover of the box.

With the packing box of the above configuration, semiconductor products may be packed without a bag or any other individual covering, and they are stably held by the cushioning material. Consequently, the semiconductor products do not shake despite vibrations that may occur during transport, thereby protecting fragile lead terminals. In addition, since the lead terminal array of the semiconductor products penetrate into the electrically conductive foam or sponge to cause short-circuiting between the lead terminals, the semiconductor products are completely protected from gate breakdown due to electrostatic voltages. There is thus no need for each semiconductor product to be put in a conductive bag or other such device to protect against such breakdown.

Furthermore, when the semiconductor products are required to be removed from the packing box, the box is turned upside down to rest on its cover, and the box is lifted off the cover. The box is then unpacked: the products are removed from the box with the lead terminals still inserted in the conductive foam or sponge on the cover. As a result, the products can be simply removed individually from the cover by holding the insulated resin package by hand without touching the lead terminals.

An embodiment of this invention will now be described in detail, with reference to the accompanying drawings, in which:
Figure 1 is an explanatory drawing illustrating a procedure for packing semiconductor products together with a packing box in accordance with this invention;
Figure 2 is a partial sectional view of the packing box from Figure 1 with the semiconductor products in their packed state;
Figure 3 is an explanatory drawing illustrating a procedure for unpacking the packing box from Figure 1 and removing the semiconductor products;
Figure 4 is an outline drawing of a lead terminal type semiconductor device for which this invention is intended; and
Figure 5 is an explanatory drawing illustrating a packing box as well as a conventional procedure for packing semiconductor products.

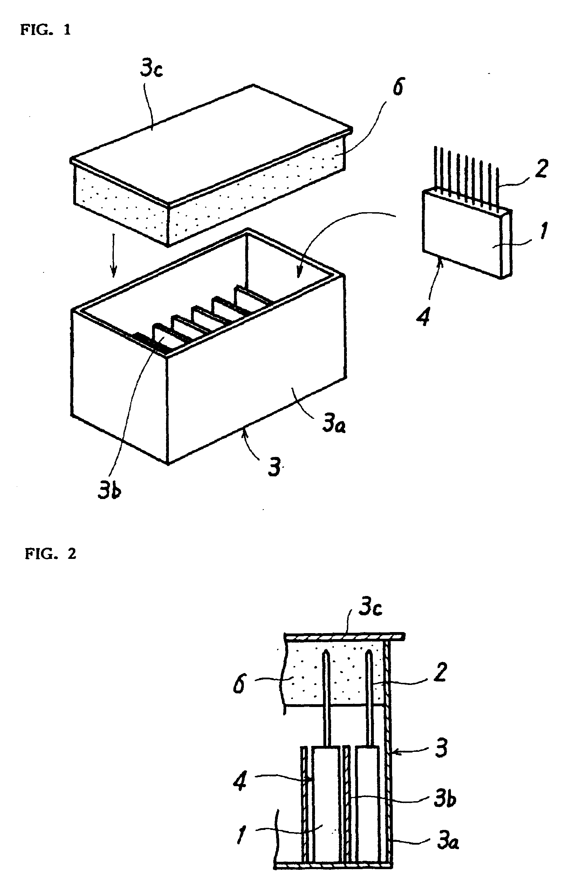

Referring now to Figure 1, a packing box 3 is shown to comprise a box body 3a, internal partitions 3b, a cover 3c, and a conductive foam or sponge 6 attached to the internal surface of the cover 3c to serve as a cushioning material. This cushioning material is preferably a soft foam formed by mixing an electrically conductive powder and a foaming agent in a resin material. The rigidity of the foam is controlled to allow the lead terminals of the semiconductor product to penetrate easily into this material. Each single in-line lead terminal type semiconductor product 4, including at least one insulated gate type semiconductor element, can be fitted between the internal partitions 3b with the lead terminals 2 directed upwardly. The cover 3c is then placed on the box. The box is shown in its packed state in Figure 2.

The inner partitions 3b inside the box body 3a are of nearly the same height as the dimension of the package 1 of the semiconductor product 4 measured parallel to the lead terminals 2. On the other hand, the conductive foam or sponge 6 has nearly the same area as the opening of the box body 3a and is attached to the internal surface of the cover 3c. The conductive foam or sponge 6 is of a thickness that allows at least the tips of the lead terminals 2 protruding from the package 1 to penetrate into the foam or sponge 6 in the packed state, as shown in Figure 2.

With this configuration, when the semiconductor products 4 are arranged in the packing box 3 and the cover is placed on the box, the conductive foam or sponge 6 serves as a cushioning material to collectively hold the products 4 in the box, as shown in Figure 2. Therefore, the semiconductor products 4 are stably held in place in the box without being shaken, even if vibrations occur during transport. In this way, the lead terminals 2, which have little mechanical strength, are protected from being damaged. The penetration of the lead terminals 2 of the semiconductor products 4 into the conductive foam or sponge 6 causes short-circuiting between the terminals; the product 4 is thereby protected from gate breakdown due to external electrostatic voltages.

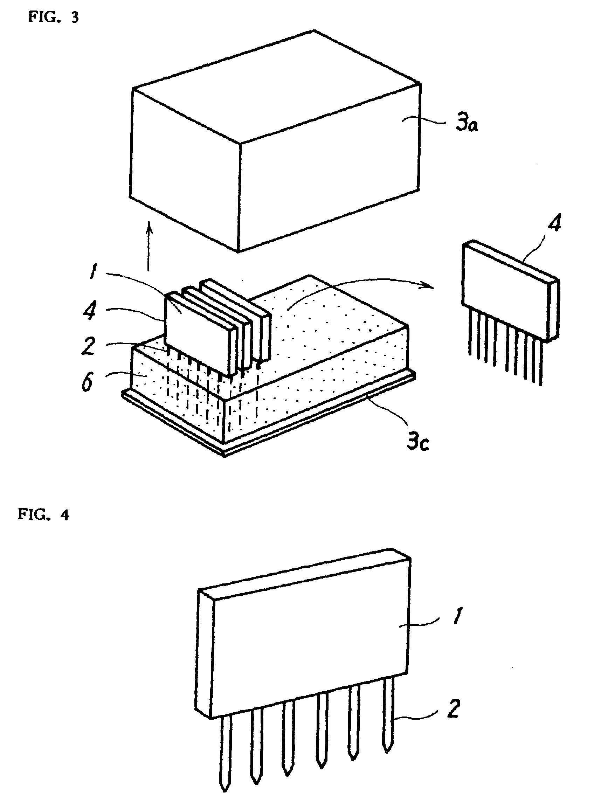

At the unpacking destination, when the semiconductor products 4 are to be removed from the packing box 3, the box 3 is turned upside down so that the cover 3c faces downward as shown in Figure 3, and the box body 3a is then lifted off the cover 3c. During this operation, the lead terminals 2 are held in place by the conductive foam or sponge 6, and the semiconductor products 4 are finally presented with their packages 1 facing upward. The operator can thereby individually remove the products 4 while holding the package 1, without touching the lead terminals 2. The handling risk is significantly reduced by avoiding touching the lead terminals 2, since particularly if the ambient air is dry, the static electricity generated in the operator's body may be discharged in to the lead terminal when it is touched, causing the semiconductor gate device to break down.

As described above, this invention allows semiconductor products to be easily inserted into and removed from the packing box, it eliminates the need for any individual treatment of the semiconductor devices to protect against gate breakdown due to electrostatic voltages, and it prevents the gate or lead terminal from being damaged as a result of electrostatic voltages or vibrations that may occur during transport. The semiconductor products are thus protected throughout the processes from packing to removal from the box.

## Claims

1. A packing method applied to lead terminal type semiconductor devices, including insulated gate type semiconductor devices such as MOSFETs and IGBTs, wherein a plurality of products are arranged in a packing box with their lead terminals extending in parallel toward an open side of the packing box, and a conductive cushioning material is pressed against the lead terminals of the semiconductor product to collectively hold the products in place.

2. The packing method of Claim 1 wherein the cushioning material is a conductive foam or sponge into which the lead terminals of the semiconductor product can easily penetrate.

3. A packing box for use with single in-line lead terminal type semiconductor devices, including insulated gate type semiconductor devices such as MOSFETs and IGBTs, the box being adapted to accommodate a plurality of products with their lead terminals arranged facing upwardly, and incorporates as a cushioning material for collectively holding the products in place an electrically conductive foam or sponge that is pressed against the lead terminals of each semiconductor product.

4. The packing box for lead terminal type semiconductor products of Claim 3, wherein the conductive foam or sponge is attached to the internal surface of the cover of the packing box.

5. The packing box for lead terminal type semiconductor products of Claim 4, wherein the conductive foam or sponge is of a thickness to allow the lead terminals of the semiconductor product to penetrate into the foam or sponge attached to the box's cover.

6. A pack of in-line lead terminal type semiconductor devices, comprising a plurality of semiconductor devices each having a resin package and a plurality of lead terminals extending out of the package in a parallel planar array, a box having a box body with an open top and a cover to close the box body top, the box body being capable of accommodating the semiconductor devices in separated enclosures with the lead terminals of the semiconductor devices extending towards the top of the box, and wherein the box cover is provided on its internal surface with a layer of electrically conductive material into which the lead terminals can penetrate when the cover is applied to the box body.

7. A pack of in-line lead terminal type semiconductor devices according to claim 6, wherein the box body is parallelipipedal in shape with a width corresponding to the dimension of a semiconductor package measured in a direction perpendicular to its lead terminals and a height corresponding to the overall dimension of the semiconductor device measured in the direction of its lead terminals, and includes internal partitions extending vertically to an extent substantially equal to the dimension of the semiconductor package measured in the direction of its lead terminals, and wherein the box cover has a layer of electrically conductive material of a thickness equal to or less than the length of the lead terminals.
